# EUROPEAN PATENT SPECIFICATION

(11) **EP 2 700 963 B1**
(45) Date of publication and mention of the grant of the patent: **21.10.2015**
(21) Application number: 12826302.7
(22) Date of filing: 19.07.2012
(51) Int. Cl.: G01R 31/36, G06Q 50/06, H01M 10/42, H04Q 9/00

(54) **STORAGE CELL STATE NOTIFYING SYSTEM, STORAGE CELL STATE NOTIFYING METHOD, AND STORAGE CELL STATE NOTIFYING PROGRAM**
SYSTEM ZUR MELDUNG DES STATUS EINER SPEICHERZELLE, VERFAHREN ZUR MELDUNG DES STATUS EINER SPEICHERZELLE UND PROGRAMM ZUR MELDUNG DES STATUS EINER SPEICHERZELLE
SYSTÈME, PROCÉDÉ ET PROGRAMME DE NOTIFICATION D'ÉTAT D'ÉLÉMENTS D'ACCUMULATEURS

(30) Priority: 22.08.2011 JP 2011180754
(43) Date of publication of application: 26.02.2014
(73) Proprietor: NEC Corporation, Tokyo 108-8001 (JP)
(72) Inventor: OKABE, Toshiya, Tokyo 108-8001 (JP)
(74) Representative: Betten & Resch
(86) International application number: PCT/JP2012/004593
(87) International publication number: WO 2013/027327

(56) References cited:
- EP-A2- 1 786 057
- JP-A- H0 398 428
- JP-A- H0 556 628
- JP-A- 2000 285 968
- JP-A- 2002 330 557
- JP-A- 2007 165 040
- US-A1- 2007 205 908

## Description

### Technical Field

The present invention relates to a storage cell state notifying system for notifying a state of a storage cell, a storage cell state notifying method, and a storage cell state notifying program.

### Background Art

At present, there is known a system for measuring a state of a storage cell and notifying the measurement result to a designated party. Such a system periodically measures a state of a storage cell and stores measurement results. Further, the system notifies the measurement result to a device in response to an instruction of a person or the device for maintaining the storage cell.

PLT 1 describes therein an over-discharge preventing device for preventing an over-discharge state of a storage cell. The over-discharge preventing device described in PLT 1 measures a discharge current and a charge current output from a storage cell, and calculates a remaining capacity of the storage cell based on the values.

PLT 2 describes a cell information monitoring device for smoothly reusing a secondary cell module. The cell information monitoring device described in PLT 2 previously defines thresholds of an internal resistance, a current, a capacity, and the like of the cell for determining a life-span of the secondary cell. The cell information monitoring device described in PLT 2 monitors a predetermined electrically-specific value as needed, and notifies the need of replacing the cell to a controller before the value reaches the threshold.

PLT 3 describes therein a maintenance system for maintaining a power receiving device for receiving supplied power from a distributed power generating system. The maintenance system described in PLT 3 monitors an operation state of each power receiving device, and creates maintenance information when a maintenance is needed. The maintenance system described in PLT 3 selects an optimum maintenance operator based on maintenance information, and asks it to perform maintenance.

### Citation List

### Patent Literature

PLT1: JP 2000-285968 A
PLT2: JP 2007-141464 A
PLT3: JP 2004-201497 A

In US 2007/205908 A1, a method and apparatus are provided to indicate battery capacity status. Different blinking frequencies of the LED correspond to different battery states of charge. The method for charge storage component status indication, comprises: determining the state of charge of said charge storing component; generating a pulse width modulated signal based on said state of charge, said pulse width modulated signal having pulses that have widths modulated to cause periodic exponential increases and decreases in an average current flowing in at least one LED; and providing said pulse width modulated signal to said at least one LED, wherein said average current has a frequency that causes said LED to blink at a predetermined blinking frequency.

### Summary of Invention

### Technical Problem

However, when a notification is made to a manufacturer of a storage cell or an operator in charge of maintenance when the storage cell enters a predefined state as in the device or system described in PLTs 1 to 3, a response thereto may be delayed. For example, when an alarm indicating a failure is notified, the storage cell is unusable at this point of time in many cases. Even if handling is conducted after the notification of the alarm, the storage cell is unusable during the handling. Therefore, it is desirable for the manufacturer or operator to sequentially monitor the storage cell thereby previously grasping a state of the storage cell.

For example, when detecting that the remaining capacity of the storage cell is lower than the amount required for driving a stator motor, the over-discharge preventing device described in PLT 1 outputs an alarm signal. The cell information monitoring device described in PLT 2 does not notify the need of replacing the cell until the remaining life of the secondary cell is a predetermined value or less. In this way, it is desirable to previously grasp the need of handling before the handling of the storage cell is needed.

On the other hand, when the storage cell is sequentially monitored, a frequency to notify a state of the storage cell being monitored and a frequency to store measurement information of the storage cell being monitored are important. For more detailed monitoring of the state, a notification frequency is higher, which causes an increase in communication load. For storage of more measurement information, the amount of data increases, which causes a strain on the capacity of a storage device.

It is therefore an exemplary object of the present invention to provide a storage cell state notifying system capable of properly determining a frequency to notify a state of a storage cell being monitored as defined in the claim 1, a storage cell state notifying method as defined in the claim 7, and a storage cell state notifying program as defined in the claim 9. Solution to Problem

The present invention is defined in the independent claims. The dependent claims define embodiments of the present invention.

### Advantageous Effects of Invention

According to the present invention, it is possible to properly determine a frequency to notify a state of a storage cell being monitored.

### Brief Description of Drawing

[Fig. 1] It depicts a block diagram illustrating a storage cell state notifying system according to one exemplary embodiment of the present invention.
[Fig. 2] It depicts a flowchart illustrating exemplary operations of the storage cell state notifying system according to the present invention.
[Fig. 3] It depicts a block diagram illustrating a variant of the storage cell state notifying system according to the present invention.
[Fig. 4] It depicts an explanatory diagram illustrating an exemplary temporal change in the remaining amount of a storage cell.
[Fig. 5] It depicts a block diagram illustrating an exemplary minimum structure of a storage cell state notifying system according to the present invention.

### Description of Embodiments

An exemplary embodiment of the present invention will be described below with reference to the drawings.

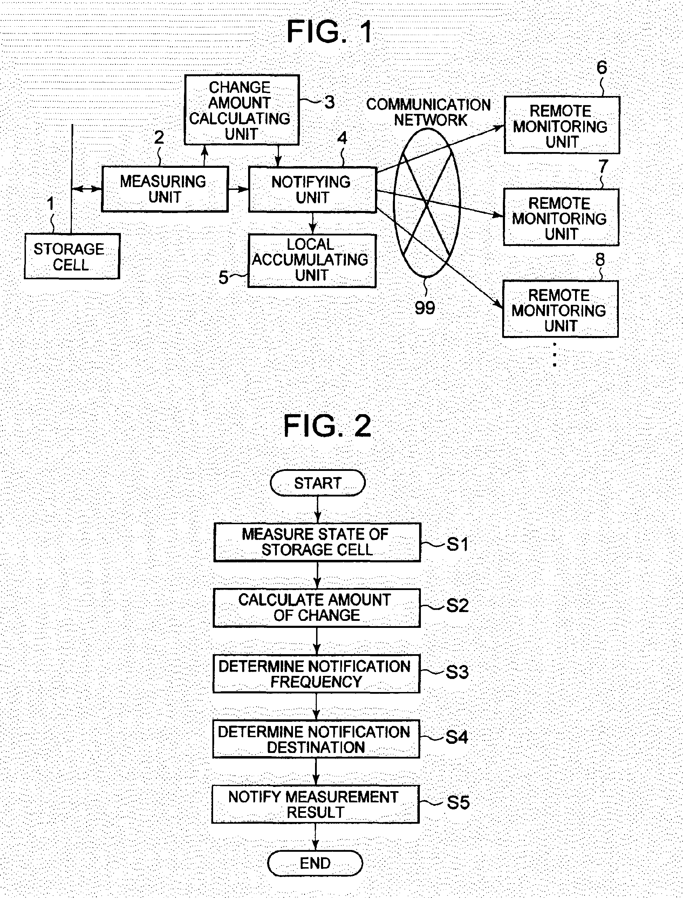

Fig. 1 is a block diagram illustrating a storage cell state notifying system according to one exemplary embodiment of the present invention. The storage cell state notifying system according to the present exemplary embodiment includes a storage cell 1, a measuring unit 2, a change amount calculating unit 3, a notifying unit 4, and a local accumulating unit 5. The notifying unit 4 is connected to remote monitoring units 6 to 8 for remotely monitoring a state of the storage cell 1 to be notified via a communication network 99. Three remote monitoring units are illustrated in Fig. 1, but the number of remote monitoring units is not limited to three.

The storage cell 1 is to be monitored, and is charged and discharged in response to an instruction from an external device (not illustrated) or based on a measurement result of the cell at a specific part.

The measuring unit 2 measures a state of the storage cell 1. Specifically, the measuring unit 2 periodically measures a voltage, a current, and the remaining amount of the storage cell 1. The measuring unit 2 may measure the number of times of switching from charge to discharge within a predetermined period, or a charge speed.

The change amount calculating unit 3 calculates the amount of change of a measurement value indicating a state measured by the measuring unit 2 (which may be denoted as measurement result below). The amount of change calculated by the change amount calculating unit 3 may be the amount of change of a measurement value itself, or a degree of change of the amount of change (or a tilt of the amount of change) . The change amount calculating unit 3 determines a frequency to notify a measurement result depending on the calculated amount of change.

For example, a plurality of thresholds used for comparison with the amount of change are previously defined. At this time, the change amount calculating unit 3 may determine to increase a notification frequency whenever the calculated amount of change exceeds each threshold. The notification frequency calculating method is not limited to the above method. For example, there may be predefined a rule in which a range of the amount of change and a notification frequency when the amount of change is within the range are associated. At this time, the change amount calculating unit 3 may determine a notification frequency associated with the amount of change calculated by the measuring unit 2 as a frequency to notify a measurement result.

Since it is assumed that as the amount of change is larger, the need of notification is higher, the change amount calculating unit 3 may determine to increase a notification frequency as the amount of change of a measured state is larger.

The change amount calculating unit 3 may determine a notification destination (such as the remote monitoring units 6 to 8) of a measurement result based on the amount of change. For example, when a rule is previously defined in which information indicating the amount of change and a notification destination of a measurement result are associated, the change amount calculating unit 3 may determine to notify a measurement result to a notification destination corresponding to the amount of change calculated by the measuring unit 2.

The notifying unit 4 notifies information indicating a state of the storage cell 1 (or a measurement result) at the notification frequency determined by the change amount calculating unit 3. The notification destination may be previously defined or determined by the change amount calculating unit 3. The remote monitoring units 6 to 8 receive the measurement result notified from the notifying unit 4 and monitor a state of the storage cell 1.

The notifying unit 4 stores the measurement result in the local accumulating unit 5 at the same frequency as the notification frequency determined by the change amount calculating unit 3, for example. A frequency at which the notifying unit 4 stores a measurement result in the local accumulating unit 5 may be the same as or different from the notification frequency.

The local accumulating unit 5 stores the measurement result measured by the measuring unit 2. The local accumulating unit 5 is realized in a magnetic disk or the like, for example.

The measuring unit 2, the change amount calculating unit 3, and the notifying unit 4 are realized in a CPU of a computer operating according to a program (storage cell state notifying program) . For example, the program is stored in a storing unit (not illustrated) of the device including the storage cell 1, the measuring unit 2, the change amount calculating unit 3, the notifying unit 4 and the local accumulating unit 5, and the CPU reads the program and may operate as the measuring unit 2, the change amount calculating unit 3 and the notifying unit 4 according to the program. The measuring unit 2, the change amount calculating unit 3 and the notifying unit 4 may be realized in dedicated hardware, respectively.

The operations of the storage cell state notifying system according to the present exemplary embodiment will be described below. Fig. 2 is a flowchart illustrating exemplary operations of the storage cell state notifying system according to the present exemplary embodiment. The flowchart in Fig. 2 illustrates a processing of determining a notification destination of a measurement result depending on the amount of change of a state of the storage cell 1.

The following description assumes that the remote monitoring unit 6 corresponds to a storage cell manufacturer, the remote monitoring unit 7 corresponds to an operator in charge of field maintenance, and the remote monitoring unit 8 corresponds to an operator operating a storage cell.

The measuring unit 2 periodically (such as a cycle of 100 milliseconds) measures the states of the storage cell 1 such as voltage, current, remaining capacity, the number of times of switching from charge to discharge, and charge speed. The measuring unit 2 may periodically measure a temperature or a humidity (step S1).

The change amount calculating unit 3 determines a frequency to notify a measurement result depending on the amount of change of the measured state. Specifically, the change amount calculating unit 3 calculates the amount of change or a tilt of the amount of change per measurement value indicating each state measured by the measuring unit 2 (step S2). The change amount calculating unit 3 determines a notification frequency based on the amount of change or the tilt of the amount of change (step S3). For example, a plurality of thresholds are previously set. At this time, the change amount calculating unit 3 may determine to increase the notification frequency whenever a threshold is exceeded.

The change amount calculating unit 3 determines a notification destination to be notified to the notifying unit 4 in relation with the notification destination preset per threshold of the amount of change (step S4). For example, the number of times of switching from charge to discharge influences a life-span of the storage cell. Therefore, when charging and discharging are repeated many times, the change amount calculating unit 3 may determine the remote monitoring unit 6 corresponding to a storage cell manufacturer as a notification destination. Specifically, when the number of times of switching from charge to discharge per unit time exceeds a predefined threshold, the change amount calculating unit 3 determines to notify measurement information to a predetermined notification destination. That is, in the present exemplary embodiment, the state of the storage cell is sequentially monitored, thereby measuring the number of times of switching per unit time. Therefore, a frequency to notify a measurement result can be properly determined.

If a charge speed rapidly changes or a discharge speed changes, the storage cell can be broken. In this case, the change amount calculating unit 3 may determine the remote monitoring unit 7 corresponding to an operator in charge of field maintenance as a notification destination. Specifically, when a tilt of the amount of change in discharge per unit time exceeds a predefined threshold, the change amount calculating unit 3 determines to notify measurement information to a predetermined notification destination. That is, according to the present exemplary embodiment, the state of the storage cell is sequentially monitored, thereby monitoring a tilt of the amount of change in discharge. Therefore, a frequency to notify a measurement result can be properly determined.

When the remaining amount of the cell changes, the change amount calculating unit 3 may determine the remote monitoring unit 8 corresponding to an operator (such as electricity company or service provider) operating a storage cell as a notification destination. Then, the notifying unit 4 notifies the measurement result to the notification destination notified from the change amount calculating unit 3 (step S5).

As described above, according to the present exemplary embodiment, the measuring unit 2 measures a state of the storage cell 1, and the change amount calculating unit 3 determines a frequency to notify a measurement result depending on the amount of change of the measured state. The notifying unit 4 notifies information indicating the state of the storage cell to the remote monitoring unit or the like at the frequency determined by the change amount calculating unit 3. Therefore, a frequency to notify the state of the storage cell 1 being monitored can be properly determined.

According to the present exemplary embodiment, the change amount calculating unit 3 determines a notification destination to which the information indicating the state of the storage cell 1 is to be notified depending on the amount of change of the measured state (specifically, the amount of change or a tilt of the amount of change). That is, the switching of a notification destination is assumed depending on a measurement value state according to the present exemplary embodiment, and thus constant notifications to the same party can be prevented.

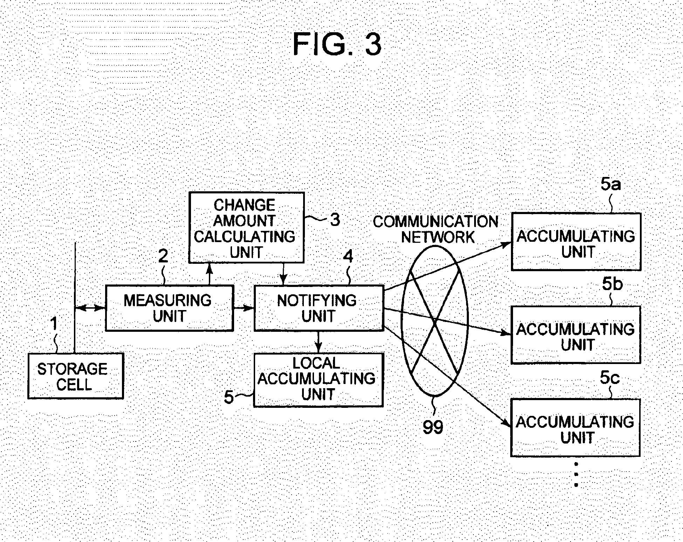

A variant of the present exemplary embodiment will be described below. The same constituents as in the above exemplary embodiment are denoted with the same reference numerals as in Fig. 1, and an explanation thereof will be omitted. Fig. 3 is a block diagram illustrating the variant of the storage cell state notifying system according to the present exemplary embodiment. The storage cell state notifying system according to the present variant also includes the storage cell 1, the measuring unit 2, the change amount calculating unit 3, the notifying unit 4 and the local accumulating units 5. In the present variant, the notifying unit 4 is connected with accumulating units 5a to 5c for accumulating measurement results therein via the communication network 99. The accumulating units 5a to 5c may be directly connected to the notifying unit 4. Three accumulating units are illustrated in Fig. 3, but the number of accumulating units is not limited to three.

The change amount calculating unit 3 determines an accumulating unit for storing information indicating a state of the storage cell (or a measurement result) depending on the amount of change in the measured state. The accumulating units to be determined by the change amount calculating unit 3 may include the local accumulating unit 5. The change amount calculating unit 3 may determine an accumulating unit in the same method as the method for determining a notification destination of a measurement result according to the above exemplary embodiment, for example. That is, for example, when there is previously defined a rule in which information indicating the amount of change and a storage destination of a measurement result are associated, the change amount calculating unit 3 may determine to store a measurement result in a storage destination corresponding to the amount of change calculated by the measuring unit 2.

The notifying unit 4 stores a measurement result in an accumulating unit determined by the change amount calculating unit 3. At this time, the notifying unit 4 may store a measurement result in the accumulating unit at the same frequency as the notification frequency determined by the change amount calculating unit 3.

As described above, according to the present variant, the change amount calculating unit 3 determines a notification destination to which the information indicating the state of the storage cell 1 is to be notified depending on the amount of change of the state measured by the measuring unit 2. Therefore, a storage destination of a measurement result can be changed depending on the contents of the measurement result. In other words, a storage destination of a measurement result can be changed depending on a state of the storage cell.

### [Examples]

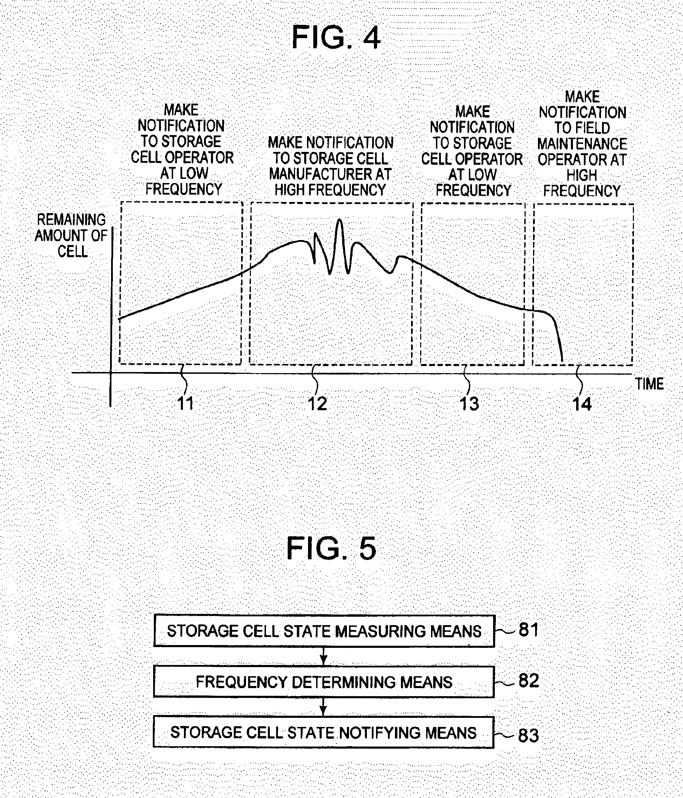

The present invention will be described below by way of specific examples, but the present invention is not limited to the contents described blow. Fig. 4 is an explanatory diagram illustrating an exemplary temporal change in the remaining amount of a storage cell. In the present example, it is assumed that the measuring unit 2 measures states 11 to 14 illustrated in Fig. 4.

All the states 11 to 14 indicate a change in the remaining amount of cell. Therefore, the notifying unit 4 notifies the measurement result to a storage cell operator as needed. In the state 11 and the state 13, a change in the remaining amount of cell is less. Thus, the notifying unit 4 notifies information indicating the remaining amount of cell to the storage cell operator at a low frequency.

On the other hand, the state 12 indicates that charging and discharging are repeated. In this case, the notifying unit 4 notifies the measurement result to the storage cell manufacturer at a high frequency. The state 14 indicates that the remaining amount of cell rapidly changes. In this case, the notifying unit 4 notifies the measurement result to the field maintenance operator at a high frequency. In this way, the notification frequency is changed depending on a state of the storage cell 1, thereby preventing a communication load from being always high.

An exemplary minimum structure of the present invention will be described below. Fig. 5 is a block diagram illustrating an exemplary minimum structure of the storage cell state notifying system according to the present invention. The storage cell state notifying system according to the present invention includes a storage cell state measuring means 81 (such as the measuring unit 2) for measuring states (such as voltage, current, the remaining amount of cell, the number of times of switching from charge to discharge within a predetermined period, and charge speed) of a storage cell (such as the storage cell 1), a frequency determining means 82 (such as the change amount calculating unit 3) for determining a frequency to notify a measurement result (or a notification frequency) depending on the amount of change of a measured state (such as the amount of change of a measurement value itself, or a tilt of the amount of change), and a storage cell state notifying means 83 (such as the notifying unit 4) for notifying information indicating a state of the storage cell at the frequency determined by the frequency determining means 82.

With the structure, a frequency to notify a state of the storage cell being monitored can be properly determined.

The storage cell state notifying system may include a measurement result storing means (such as the local accumulating unit 5) for storing information indicating a state of the storage cell therein. The storage cell state notifying means 83 may store information indicating a measured state of the storage cell in the measurement result storing means. The storage cell state notifying means 83 may store information indicating a measured state of the storage cell in the measurement result storing means at a frequency to notify the information. With the structure, the amount of measurement results to be stored can be properly adjusted depending on a state of the storage cell. That is, not only a frequency to notify a state of the storage cell being monitored but also a frequency to store measurement information can be properly determined.

The storage cell state notifying system may include a plurality of measurement result storing means (such as the local accumulating unit 5 and the accumulating units 5a to 5c). The frequency determining means 82 may determine a measurement result storing means for storing information indicating a state of the storage cell therein depending on the amount of change in a measured state. The storage cell state notifying means 83 may store information indicating a measured state of the storage cell in the measurement result storing means determined by the frequency determining means. With the structure, the information can be stored in a proper storing means in a distributed manner depending on a state of the storage cell.

The frequency determining means 82 may determine a notification destination to which information indicating a state of the storage cell is to be notified depending on the amount of change in the measured state. With the structure, a measurement result can be notified to a proper notification destination depending on a state of the storage cell.

The frequency determining means 82 may set a frequency to notify a measurement result to be high as the amount of change in a measured state is larger.

The present invention has been described above with reference to the exemplary embodiment and the examples, but the present invention is not limited to the exemplary embodiment and the examples. Those skilled in the art can variously change the structure and details of the present invention within the scope of the present invention.

### Industrial Applicability

The present invention is applicable to a system for notifying a state of a fixed storage cell which is installed at home or public facilities, which is expected to be widely used. For example, the present invention is applicable to a monitoring device for remotely monitoring an operation state of a fixed storage cell or a log accumulating device for accumulating operation logs. The present invention is applicable to a state monitoring device for monitoring a state of a storage cell in a product mounting the storage cell thereon.

### Reference Signs List

- 1: Storage cell
- 2: Measuring unit
- 3: Change amount calculating unit
- 4: Notifying unit
- 5: Local accumulating unit
- 6-8: Remote monitoring unit
- 99: Communication network

## Claims

1. A storage cell state notifying system comprising:
a storage cell state measuring means (2) for measuring a state of a storage cell (1);
a frequency determining means (3) for determining a frequency to notify the measurement result depending on the amount of temporal change of the measured state; and
a storage cell state notifying means (4) for notifying information indicating the state of the storage cell (1) at the frequency determined by the frequency determining means (3).

2. The storage cell state notifying system according to claim 1, comprising:
a measurement result storing means (5) for storing information indicating a state of the storage cell (1),
wherein the storage cell state notifying means (4) stores information indicating the measured state of the storage cell (1) in the measurement result storing means (5).

3. The storage cell state notifying system according to claim 2, wherein the storage cell state notifying means (4) stores information indicating the measured state of the storage cell (1) in the measurement result storing means (5) at the frequency to notify the information.

4. The storage cell state notifying system according to claim 2 or claim 3, comprising:
a plurality of measurement result storing means (5),
wherein the frequency determining means (3) determines a measurement result storing means (5) for storing the information indicating the state of the storage cell (1) therein depending on the amount of temporal change in the measured state, and
the storage cell state notifying means (4) stores the information indicating the measured state of the storage cell (1) in the measurement result storing means (5) determined by the frequency determining means (3).

5. The storage cell state notifying system according to claim 1 to claim 4, wherein the frequency determining means (3) determines a notification destination to which the information indicating the state of the storage cell (1) is to be notified depending on the amount of temporal change in the measured state.

6. The storage cell state notifying system according to claim 1 to claim 5, wherein the frequency determining means (3) sets a frequency to notify a measurement result to be higher as the amount of temporal change in a measured state is larger.

7. A storage cell state notifying method comprising the steps of:
measuring a state of a storage cell (S1);
determining a frequency (S3) to notify the measurement result depending on the amount of temporal change in the measured state; and
notifying information (S5) indicating the state of the storage cell at the determined frequency.

8. The storage cell state notifying method according to claim 7, comprising the step of storing the information indicating the measured state of the storage cell in a measurement result storing means at the frequency to notify the information.

9. A storage cell state notifying program for causing a computer to perform:
a storage cell state measurement processing (S1) of measuring a state of a storage cell;
a frequency determination processing (S3) of determining a frequency to notify the measurement result depending on the amount of temporal change in the measured state; and
a storage cell state notification processing (S5) of notifying information indicating the state of the storage cell at the frequency determined in the frequency determination processing.

10. The storage cell state notifying program according to claim 9, the program causing a computer to store the information indicating the measured state of the
storage cell in a measurement result storing means at the frequency to notify the information in the storage cell state notification processing.

## Patentansprüche

1. Speicherzellenzustand-Benachrichtigungssystem, umfassend:
ein Speicherzellenzustand-Messmittel (2) zum Messen eines Zustands einer Speicherzelle (1);
ein Frequenz-Bestimmungsmittel (3) zum Bestimmen einer Frequenz, um das Messergebnis in Abhängigkeit vom Umfang zeitlicher Änderung des gemessenen Zustands zu benachrichtigen; und
ein Speicherzellenzustand-Benachrichtigungsmittel (4) zum Benachrichtigen von Information, welche den Zustand der Speicherzelle (1) angibt, mit einer durch das Frequenz-Bestimmungsmittel (3) bestimmten Frequenz.

2. Speicherzellenzustand-Benachrichtigungssystem nach Anspruch 1, umfassend:
ein Messergebnis-Speichermittel (5) zum Speichern von Information, welche einen Zustand der Speicherzelle (1) angibt,
wobei das Speicherzellenzustand-Benachrichtigungsmittel (4) Information, welche den gemessenen Zustand der Speicherzelle (1) angibt, in dem Messergebnis-Speichermittel (5) speichert.

3. Speicherzellenzustand-Benachrichtigungssystem nach Anspruch 2, wobei das Speicherzellenzustand-Benachrichtigungsmittel (4) Information, welche den gemessenen Zustand der Speicherzelle (1) angibt, in dem Messergebnis-Speichermittel (5) mit der Frequenz speichert, um die Information zu benachrichtigen.

4. Speicherzellenzustand-Benachrichtigungssystem nach Anspruch 2 oder Anspruch 3, umfassend:
eine Mehrzahl von Messergebnis-Speichermitteln (5),
wobei das Frequenz-Bestimmungsmittel (3) ein Messergebnis-Speichermittel (5) zum Speichern der Information, welche den Zustand der Speicherzelle (1) angibt, in Abhängigkeit vom Umfang zeitlicher Änderung in dem gemessenen Zustand, und
das Speicherzellenzustand-Benachrichtigungsmittel (4) die Information, die den gemessenen Zustand der Speicherzelle (1) angibt, in dem Messergebnis-Speichermittel (5) speichert, welches durch das Frequenz-Bestimmungsmittel (3) bestimmt ist.

5. Speicherzellenzustand-Benachrichtigungssystem nach Anspruch 1 bis Anspruch 4, wobei das Frequenz-Bestimmungsmittel (3) ein Benachrichtigungsziel, an welches die Information zu benachrichtigen ist, welche den Zustand der Speicherzelle (1) angibt, in Abhängigkeit vom Umfang zeitlicher Änderung des gemessenen Zustands bestimmt.

6. Speicherzellenzustand-Benachrichtigungssystem nach Anspruch 1 bis Anspruch 5, wobei das Frequenz-Bestimmungsmittel (3) eine Frequenz einstellt, um ein Messergebnis zu benachrichtigen, welches höher ist, wenn der Umfang zeitlicher Änderung in einem gemessenen Zustand größer ist.

7. Speicherzellenzustand-Benachrichtigungsverfahren, umfassend die Schritte:
Messen eines Zustands einer Speicherzelle (S1);
Bestimmen einer Frequenz (S3), um das Messergebnis zu benachrichtigen, in Abhängigkeit vom Umfang zeitlicher Änderung in dem gemessenen Zustand; und
Benachrichtigen von Information (S5), welche den Zustand der Speicherzelle angibt, mit der bestimmten Frequenz.

8. Speicherzellenzustand-Benachrichtigungsverfahren nach Anspruch 7, umfassend den Schritt des Speicherns der Information, die den gemessenen Zustand der Speicherzelle angibt, in einem Messergebnis-Speichermittel mit der Frequenz, um die Information zu benachrichtigen.

9. Speicherzellenzustand-Benachrichtigungsprogramm zum Veranlassen eines Computers, auszuführen:
eine Speicherzellenzustand-Messverarbeitung (S1) zum Messen eines Zustands einer Speicherzelle;
eine Frequenz-Bestimmungsverarbeitung (S3) zum Bestimmen einer Frequenz, um das Messergebnis zu benachrichtigen, in Abhängigkeit vom Umfang zeitlicher Änderung in dem gemessenen Zustand; und
eine Speicherzellenzustand-Benachrichtigungsverarbeitung (S5) zum Benachrichtigen von Information, welche den Zustand der Speicherzelle angibt, mit der in der Frequenz-Bestimmungsverarbeitung bestimmten Frequenz.

10. Speicherzellenzustand-Benachrichtigungsprogramm nach Anspruch 9, wobei das Programm einen Computer veranlasst, die Information, welche den gemessenen Zustand der Speicherzelle angibt, in einem Messergebnis-Speichermittel mit der Frequenz zu speichern, um die Information in der Speicherzellenzustand-Benachrichtigungsverarbeitung zu benachrichtigen.

## Revendications

1. Système de notification d'état de cellule de stockage comprenant :
un moyen de mesure d'état de cellule de stockage (2) pour mesurer un état d'une cellule de stockage (1) ;
un moyen de détermination de fréquence (3) pour déterminer une fréquence pour notifier le résultat de mesure en fonction de la quantité de changement temporel de l'état mesuré ; et
un moyen de notification d'état de cellule de stockage (4) pour notifier des informations indiquant l'état de la cellule de stockage (1) à la fréquence déterminée par le moyen de détermination de fréquence (3).

2. Système de notification d'état de cellule de stockage selon la revendication 1, comprenant :
un moyen de stockage de résultat de mesure (5) pour stocker des informations indiquant un état de la cellule de stockage (1),
dans lequel le moyen de notification d'état de cellule de stockage (4) stocke des informations indiquant l'état mesuré de la cellule de stockage (1) dans le moyen de stockage de résultat de mesure (5).

3. Système de notification d'état de cellule de stockage selon la revendication 2, dans lequel le moyen de notification d'état de cellule de stockage (4) stocke des informations indiquant l'état mesuré de la cellule de stockage (1) dans le moyen de stockage de résultat de mesure (5) à la fréquence pour notifier les informations.

4. Système de notification d'état de cellule de stockage selon la revendication 2 ou la revendication 3, comprenant :
une pluralité de moyens de stockage de résultat de mesure (5),
dans lequel le moyen de détermination de fréquence (3) détermine un moyen de stockage de résultat de mesure (5) pour stocker les informations indiquant l'état de la cellule de stockage (1) dans celui-ci en fonction de la quantité de changement temporel dans l'état mesuré, et
le moyen de notification d'état de cellule de stockage (4) stocke les informations indiquant l'état mesuré de la cellule de stockage (1) dans le moyen de stockage de résultat de mesure (5) déterminé par le moyen de détermination de fréquence (3).

5. Système de notification d'état de cellule de stockage selon la revendication 1 à la revendication 4, dans lequel le moyen de détermination de fréquence (3) détermine une destination de notification à laquelle les informations indiquant l'état de la cellule de stockage (1) doivent être notifiées en fonction de la quantité de changement temporel dans l'état mesuré.

6. Système de notification d'état de cellule de stockage selon la revendication 1 à la revendication 5, dans lequel le moyen de détermination de fréquence (3) établit une fréquence pour notifier un résultat de mesure comme étant supérieure lorsque la quantité de changement temporel dans un état mesuré est plus grande.

7. Procédé de notification d'état de cellule de stockage comprenant les étapes consistant à :
mesurer un état d'une cellule de stockage (S1) ;
déterminer une fréquence (S3) pour notifier le résultat de mesure en fonction de la quantité de changement temporel dans l'état mesuré ; et
notifier des informations (S5) indiquant l'état de la cellule de stockage à la fréquence déterminée.

8. Procédé de notification d'état de cellule de stockage selon la revendication 7, comprenant l'étape consistant à stocker les informations indiquant l'état mesuré de la cellule de stockage dans un moyen de stockage de résultat de mesure à la fréquence pour notifier les informations.

9. Programme de notification d'état de cellule de stockage pour amener un ordinateur à exécuter :
un traitement de mesure d'état de cellule de stockage (S1) consistant à mesurer un état d'une cellule de stockage ;
un traitement de détermination de fréquence (S3) consistant à déterminer une fréquence pour notifier le résultat de mesure en fonction de la quantité de changement temporel dans l'état mesuré ; et
un traitement de notification d'état de cellule de stockage (55) consistant à notifier des informations indiquant l'état de la cellule de stockage à la fréquence déterminée dans le traitement de détermination de fréquence.

10. Programme de notification d'état de cellule de stockage selon la revendication 9, le programme amenant un ordinateur à stocker les informations indiquant l'état mesuré de la cellule de stockage dans un moyen de stockage de résultat de mesure à la fréquence pour notifier les informations dans le traitement de notification d'état de cellule de stockage.
